# EUROPEAN PATENT APPLICATION

(11) **EP 3 702 745 A1**
(43) Date of publication of application: **02.09.2020**
(21) Application number: 17929779.1
(22) Date of filing: 24.10.2017
(51) Int. Cl.: G01J 1/44, G01J 1/02, G01J 1/42, G01T 7/00, H01L 31/02

(54) **ELECTROMAGNETIC WAVE DETECTION MODULE, ELECTROMAGNETIC WAVE DETECTION MODULE ROW, AND NONDESTRUCTIVE INSPECTION DEVICE**

(71) Applicant: System Square Inc., Nagaoka-shi Niigata 9402121 (JP)
(72) Inventor: IKEDA Noriaki, Nagaoka-shi Niigata 940-2121 (JP); MORIYAMA, Junji, Nagaoka-shi Niigata 940-2121 (JP)
(74) Representative: Müller-Boré & Partner Patentanwälte PartG mbB
(86) International application number: PCT/JP2017/038376
(87) International publication number: WO 2019/082276

(57) **Abstract**

The present invention provides an electromagnetic wave detection module in which wiring is formed to connect each detection element of an electromagnetic wave detection means configured by arranging a plurality of detection elements for detecting an electromagnetic wave in a two-dimensional array and a predetermined connection destination outside the electromagnetic wave detection means with good manufacturability and so as not to cause trouble in the detection of an electromagnetic wave as much as possible. A detection element group consisting of M detection elements (M is an integer of 2 or more) arranged in the Y-axis direction is arranged in N rows (N is an integer of 2 or more) in the X-axis direction orthogonal to the Y-axis direction, and MxN wirings electrically connecting each of the M×N detection elements and a predetermined connection destination outside any one end of the electromagnetic wave detection means in the Y-axis direction are provided on the common substrate surface.

## Description

### TECHNICAL FIELD

The present invention relates to an electromagnetic wave detection module, an electromagnetic wave detection module array, and a nondestructive inspection apparatus, each of which has a configuration in which a wiring from each detection element is effectively drawn outside an electromagnetic wave detection means composed of a plurality of detection elements.

### BACKGROUND ART

In general, in each process from manufacture to packaging and shipment of products, an inspection is performed to check whether there are any foreign substances or the like in the products or packages by an inspection method suitable for the types (materials, sizes, etc.) of the products to be inspected or the foreign substances that can be mixed in.

Among these, in a nondestructive inspection using a difference in electromagnetic wave permeability for each substance, an inspection target is irradiated with an electromagnetic wave such as X-rays, and the transmitted electromagnetic wave is detected. At this time, the degree of transmission of the electromagnetic wave is different depending on the presence or absence of the foreign substances in the inspection target, the material of the foreign substances, and the like. Therefore, by generating a two-dimensional image in which the distribution of the intensity of the detected transmitted electromagnetic wave is expressed by shading or the like, it is possible to inspect the situation inside the inspection target which is not known from the appearance.

More specifically, for example, a linear sensor array orthogonal to the conveying direction of the inspection target periodically scans the transmitted electromagnetic waves transmitted through the inspection target being simultaneously set under conveyance and electromagnetic wave irradiation therewith, and sequentially generates a linear electromagnetic wave transmission image. Then, two-dimensional images of the inspection target can be generated by arranging them sequentially in the scanning direction (for example, see Patent Document 1) .

In order to read out signals from a plurality of detection elements constituting the linear sensor array, a CMOS system or a CCD system is mainly employed.

In the CMOS method, charges outputted from the respective detection elements constituting the linear sensor array are converted into electric signals by charge amplifiers, and then sequentially read out by using switches or shift registers.

As one of methods for implementing these functional units on a substrate, there is a method in which a linear sensor array composed of a plurality of detection elements and a reading unit, which is a CMOS signal-processing IC composed of a charge amplifier, a shift register, and the like, are formed on the substrate, and these units are electrically connected to each other by patterned wirings or the like.

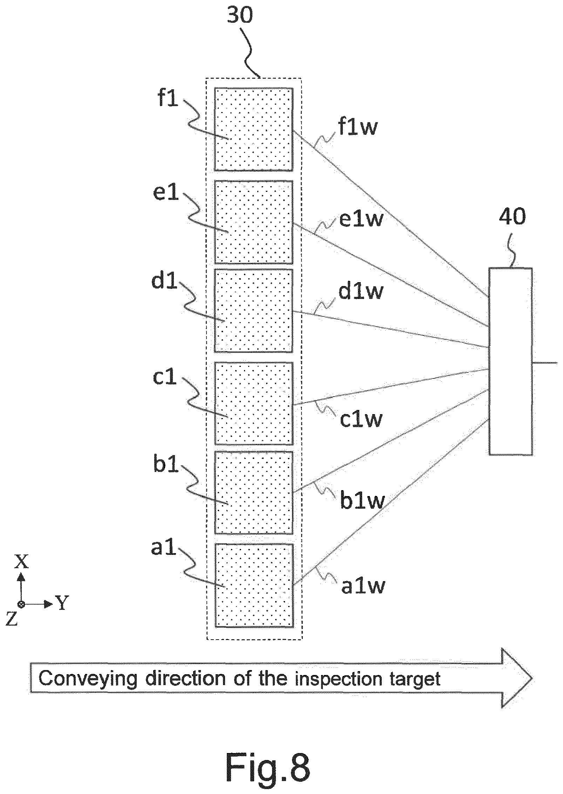

FIG. 8 shows an example in which the linear sensor array 30 which is an electromagnetic wave detection means and the reading means 40 are formed on the common substrate, and the wirings alw to f1w are formed to connect each of the six detection elements a1 to f1 constituting the linear sensor array 30 and the reading means 40.

### PRIOR ART REFERENCES

### PATENT DOCUMENTS

[Patent Document 1] Japanese Unexamined Patent Application Publication No. 2017-020843

### SUMMARY OF THE INVENTION

### PROBLEMS TO BE SOLVED BY THE INVENTION

The electromagnetic wave detection means employed in the nondestructive inspection apparatus does not necessarily have to be a linear sensor array, and, for example, a plurality of detection elements arranged in a two-dimensional array may be employed. Such an arrangement is adopted when the electromagnetic wave detection means functions as, for example, an area-sensor array or a TDI sensor array.

Such an arrangement can be realized, for example, by arranging a plurality of linear sensor arrays shown in FIG. 8 in the conveying direction of the inspection target.

However, when arranging other linear sensor arrays on the left side of the linear sensor array 30 in the drawing, since at least the linear sensor array 30 exists on the right side of the other linear sensor array, it becomes a problem how wiring is routed from each of the plurality of detection elements constituting the other linear sensor array to the reading means 40.

It is an object of the present invention to provide an electromagnetic wave detection module, an electromagnetic wave detection module array, and a nondestructive inspection apparatus in which wiring is formed to connect each detection element of an electromagnetic wave detection means configured by arranging a plurality of detection elements for detecting an electromagnetic wave in a two-dimensional array and a predetermined connection destination outside the electromagnetic wave detection means with good manufacturability and so as not to interfere with the detection of an electromagnetic wave as much as possible.

### Means for Solving the Problems

(1) The electromagnetic wave detection module of the present invention is an electromagnetic wave detection means comprising an electromagnetic wave detection means in which detection element groups of M detection elements (M is an integer of 2 or more) arranged in the Y-axis direction are arranged in N rows (N is an integer of 2 or more) in the X-axis direction orthogonal to the Y-axis direction, and M×N, a product of two integers M and N, wirings electrically connecting each of the M×N detection elements and a predetermined connection destination outside one end of the electromagnetic wave detection means in the Y-axis direction, on the same substrate surface.
   By routing the wirings in this manner, the wiring can be drawn out with a planar structure and without increasing the number of parts, so that the manufacturability is good. In addition to a simple configuration, since the wirings are not stacked on the detection element, interference with detection of electromagnetic waves due to stacking can be avoided.
(2) For all the detection element groups, the wiring from each detection element belonging to the detection element group may be routed through a gap between the detection element group and an adjacent detection element group on the same end side in the X-axis direction of the electromagnetic wave detection means.
   By routing the wirings in this manner, the wiring distance from the detection elements to the reading means or the array of terminals can be minimized, and the number of wirings to be routed through the detection elements can be limited to the number of detection elements belonging to the detection element group at most. Therefore, the wiring can be formed in such a manner that the manufacturing cost can be suppressed, the noise is hardly applied, and the detection sensitivity of the electromagnetic wave is not greatly deteriorated.
(3) The predetermined connection destination may be set for each wiring and electrically connected to each of the M×N detection elements on a one-to-one basis.
   As a result, each detection element can be connected to a separate circuit such as a charge amplifier, and the output from each detection element can be processed separately.
(4) The predetermined connection destination may also be provided outside the other end in the Y-axis direction of the electromagnetic wave detection means, and for each detection element group, the wiring from each detection element belonging to the detection element group is connected to a predetermined connection destination outside the one end from a detection element at one end with the middle of any adjacent detection element as a boundary, and the detection element at the other end is connected to a predetermined connection destination outside the other end.
   By providing the predetermined connection destinations at both ends in the Y-axis direction, wiring paths are dispersed more than when only one end or the other end is set, and the number of wiring lines routed between adjacent detection elements can be reduced. Therefore, it is possible to further suppress the reduction of the exposed area of the detection element due to the presence of the wiring, and to further suppress the decrease of the detection sensitivity.
(5) The boundary between connecting the detection element to a predetermined connection destination on one end side or to a predetermined connection destination on the other end side may be set, for example, such that the number of detection elements sandwiching the boundary becomes (M/2) when M is an even number, and such that ((M+1)/2) and ((M-1)/2) when M is an odd number.
   This makes it possible to further reduce the maximum value of the number of wirings routed between the detection elements, and to further shorten the maximum length of the wirings. Therefore, it is possible to further suppress the lowering of the detection sensitivity and to further reduce the influence of noise on the wiring.
(6) A plurality of electromagnetic wave detection modules of the present invention may be arranged in the X-axis direction to form an electromagnetic wave detection module array.
(7) In a nondestructive inspection apparatus employing the electromagnetic wave detection module or the electromagnetic wave detection module array of the present invention, it is possible to obtain excellent effects in terms of cost and performance as compared with the case of employing a conventional module.
(8) The nondestructive inspection apparatus of the present invention may further comprise an electromagnetic wave irradiation means for irradiating an inspection target with a predetermined electromagnetic wave, and a conveyance means for conveying the inspection target placed on the conveyance plane in a predetermined direction, and the electromagnetic wave detection module may be arranged in a propagation path of the electromagnetic wave from the electromagnetic wave irradiation means to the electromagnetic wave detection module through the portion of the conveyance plane on which the inspection target is placed, such that the separation distance from the conveyance plane is shorter than the separation distance between the electromagnetic wave irradiation means and the conveyance plane, and may be configured to detect the electromagnetic wave transmitted through the inspection target.
(9) The nondestructive inspection apparatus of the present invention may further include conveyance means for conveying the inspection target irradiated with the electromagnetic wave in a predetermined direction, and an electromagnetic wave detection module provided inside the conveyance means may detect the electromagnetic wave transmitted through the inspection target.

### BRIEF DESCRIPTION OF THE DRAWINGS

Fig. 1 is a functional block diagram showing an example of the configuration of a nondestructive inspection apparatus including an electromagnetic wave detection module of the present invention.
Fig. 2 is a functional block diagram showing another example of the configuration of the nondestructive inspection apparatus including the electromagnetic wave detection module of the present invention.
Fig. 3 is a diagram showing an example of the configuration of an electromagnetic wave detection module according to the first embodiment.
Fig. 4 is a diagram showing an example of the configuration in the case where the reading means in the configuration of Fig. 3 is formed on another substrate.
Fig. 5 is a diagram showing an example of the configuration of an electromagnetic wave detection module according to the second embodiment.
Fig. 6 is a diagram for explaining a detection range of a transmitted electromagnetic wave from a detection target region by each detection element belonging to a detection element group.
FIG. 7 is a diagram showing an example of the configuration of an electromagnetic wave detection module according to the third embodiment.
Fig. 8 is a diagram showing an example of the configuration of a conventional electromagnetic wave detection module.

### DESCRIPTION OF EMBODYMENTS

Hereinafter, each embodiment of the present invention will be described in detail. Although a case where the electromagnetic wave detection module of the present invention is used in a nondestructive inspection apparatus employing the TDI method will be described below as an example, it can be implemented in basically the same form and obtain the same effect even when it is used in another apparatus including electromagnetic wave detection means in which a plurality of detection elements are arranged in a two-dimensional array.

### <First Embodiment>

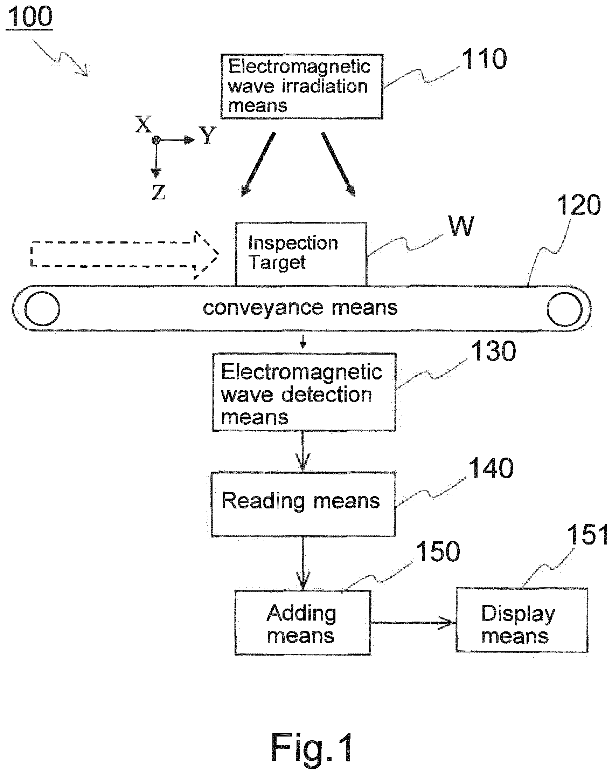

FIG. 1 is a functional block diagram of the nondestructive inspection apparatus 100. The nondestructive inspection apparatus 100 includes an electromagnetic wave irradiation means 110, a conveyance means 120, an electromagnetic wave detection means 130, a reading means 140, an adding means 150, and a display means 151.

The electromagnetic wave irradiation means 110 irradiates an electromagnetic wave such as X-rays, ultraviolet rays, visible rays, infrared rays, or the like to the inspection target W conveyed in the Y-axis direction by the conveyance means 120.

The conveyance means 120 is, for example, a belt conveyor or the like, and conveys the inspection target W placed on the conveyance plane in the Y-axis direction at a predetermined speed. It is desirable that the conveyance means 120 has high electromagnetic wave transparency so that the transmitted electromagnetic wave from the inspection target W reaches the electromagnetic wave detection means 130 with as little attenuation as possible.

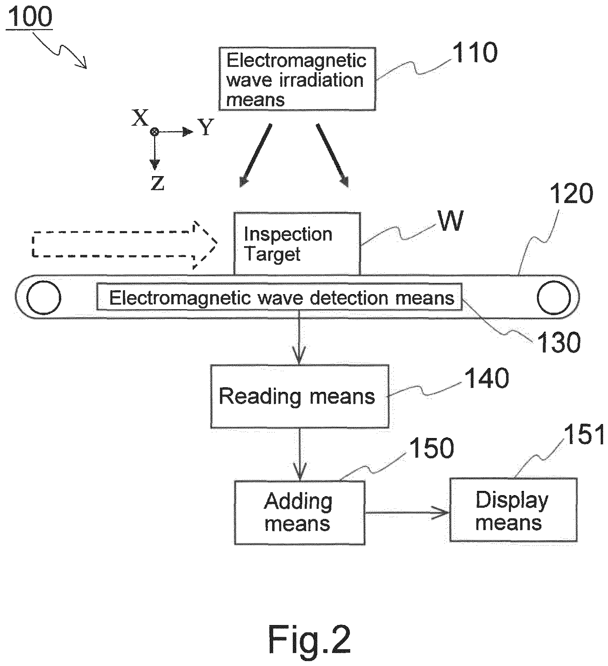

The electromagnetic wave detection means 130 is an electromagnetic wave detection module that detects an electromagnetic wave that has been irradiated from the electromagnetic wave irradiation means 110 onto the inspection target W and has transmitted through the inspection target W. Specifically, for example, in the propagation path of the electromagnetic wave from the electromagnetic wave irradiation means 110 to the electromagnetic wave detection means 130 through the portion of the conveyance plane on which the inspection target W is placed, the electromagnetic wave detection means is arranged at a position where the separation distance from the conveyance plane is shorter than the separation distance between the electromagnetic wave irradiation means and the conveyance plane, and detects the electromagnetic wave transmitted through the inspection target. By making the separation distance between the conveyance plane of the portion on which the inspection target W is placed and the electromagnetic wave detection means 130 as short as possible, the short separation distance thereabove makes it possible to detect the electromagnetic wave which has transmitted through the inspection target W and has been attenuated ,while maintaining higher intensity. In addition, while the electromagnetic wave radiated from the electromagnetic wave irradiation means 110 spreads in a conical shape and continues to spread even after transmitted through the inspection target W, detection leakage of the electromagnetic wave transmitted through the inspection target W in the electromagnetic wave detection means 130 can be prevented by making the separation distance between the conveyance plane and the electromagnetic wave detection means 130 as short as possible. The electromagnetic wave detection means 130 may be disposed outside the conveying means 120 as shown in FIG. 1, or may be disposed inside the conveyance means 120 as shown in FIG. 2. In particular, by placing inside the conveyance means 120, the nondestructive inspection apparatus 100 can be configured in a small size. Further, the separation distance between the inspection target W and the electromagnetic wave detection means 130 can be shortened. In addition, when the conveyance means 120 is a belt conveyor, attenuation of electromagnetic waves can be further suppressed because the number of times of transmission through the belt is reduced,

The electromagnetic wave detection means 130 is arranged on a substrate, and detection element groups composed of M (M is an integer of 2 or more) detection elements arranged in the Y-axis direction are arranged in N rows (N is an integer of 2 or more) in the X-axis direction orthogonal to the Y-axis direction, and for each detection element group, each detection element belonging to the detection element group sequentially detects a transmitted electromagnetic wave from the same detection target region of the inspection target W and generates an output corresponding to the detection intensity. The detection target region refers to one of a plurality of regions formed by dividing the surface of the inspection target W facing the electromagnetic wave detection means 130 into a lattice shape having a size of a region allocated to one detection element in the electromagnetic wave detection means 130.

The type of each detection element constituting the electromagnetic wave detection means 130 is arbitrary as long as it is an element that detects an electromagnetic wave to be irradiated and generates an output according to the detection intensity. Taking an example in which the electromagnetic wave irradiated on the inspection target W is X-rays, an indirect conversion type detection element that converts X-rays into visible rays by a scintillator once and then receives the light by a photo diode to generate an output, a direct conversion type detection element that utilizes semiconductors such as a CdTe that converts X-rays into direct electric signals to generate an output, or the like can be applied.

The respective outputs from the respective detection elements belonging to a detection element group are added together, thereby the brightness of the pixel corresponding to the detection target region is determined.

The function of adding the outputs from the respective detection elements belonging to the detection element group can be configured by, for example, a reading means 140 having a function of sequentially outputting the electric signals obtained by processing the outputs as necessary, and an adding means 150 for adding the electric signals sequentially output from the reading means 140.

The reading means 140 functions as a predetermined connection destination of wiring leaded from each detection element in the present embodiment, in which the reading means 140 is provided outside one end of the electromagnetic wave detection means 130 in the Y-axis direction. For example, when the input from each detection element is input in the form of a charge amount, a charge amplifier for each wiring is provided in the reading means 140, and the wiring from each detection element is electrically connected to each charge amplifier.

The reading means 140 may not necessarily be provided on a common substrate as the electromagnetic wave detection means 130, but may be provided on another substrate. In this case, an array of terminals capable of terminating the wiring from each detection element may be provided on the substrate, and the array of terminals may be connected to a reading means 140 provided on another substrate.

In the case where the reading means 140 is provided on the substrate or the case where the array of terminals is provided on the substrate, it is necessary to lead out the wiring for transmitting the output from each of the M×N detection elements to the reading means 140 or the array of terminals from the inside of the electromagnetic wave detection means 130 to the outside of the electromagnetic wave detection means 130. The electromagnetic wave detection module of the present invention is composed of the electromagnetic wave detection means 130 and such wirings, and the present invention is characterized in how to draw out the wirings.

Various methods are conceivable for drawing out the wiring, but it is desirable to draw out the wiring so as not to cause an excessive manufacturing cost due to a complicated structure and wiring or an increase in the number of components. More specifically, for example, when wiring is stacked, the structure becomes complicated, and when bus wiring is used, components such as switches are required, which leads to an increase in cost. In addition, when the wiring is stacked on the electromagnetic wave detection means 130, there is a possibility that the detection of the electromagnetic wave is hindered.

In addition, the shorter the length of the wiring, the harder the noise occurrence, so that the lowering of the detection sensitivity can be suppressed.

Further, when wiring is routed between the detection elements, it is necessary to secure a wiring space corresponding to the number of wirings. As a method of securing the space, for example, a method of gradually reducing an exposed area of the detection element (specifically, a method of gradually narrowing the element width in the direction orthogonal to the conveying direction) can be considered for employment. Not all of the detection elements provided on the substrate are necessarily exposed, and there may be a portion covered with a shield such as a wiring or aluminum that shields between the detection elements. The exposed area means an area excluding such a portion, that is, an area of a remaining portion facing the inspection target so that the transmitted electromagnetic wave can be detected when the transmitted electromagnetic wave is detected by the detection element. The exposed area of the detection elements becomes smaller as the number of wirings routed between the detection elements increases. Therefore, it is desirable that the number of wirings routed between the detection elements reduced as much as possible so that the exposed area does not become too small and the detection sensitivity of the electromagnetic wave is seriously impaired.

Therefore, in the present invention, M×N wirings, connecting each of the M×N detection elements to the reading means 140 or to the array of terminals prepared for the wirings each, are individually formed on the common substrate surface, in which the reading means 140 and the array of terminals thereof both are disposed outside one end of the electromagnetic wave detection means 130 in the Y-axis direction. At this time, for all the detection element groups, the wiring from each detection element belonging to the detection element group is routed through a gap between the detection element group and an adjacent detection element group on the same end side in the X-axis direction of the electromagnetic wave detection means.

By routing the wirings in this manner, the wiring can be drawn out with a planar structure and without increasing the number of parts, so that the manufacturability is good. In addition to a simple configuration, since the wirings are not stacked on the detection element, interference with detection of electromagnetic waves due to stacking can be avoided. Further, for all the detection element groups, since the wiring from each detection element belonging to the detection element group is routed through a gap between the detection element group and an adjacent detection element group on the same end side in the X-axis direction of the electromagnetic wave detection means 130, the wiring distance from the detection element to the reading means 140 or the array of terminals is minimized, and the number of wirings routed through the detection elements can be limited to the number of detection elements belonging to the detection element group at most.

Therefore, the wiring can be formed in such a manner that the manufacturing cost can be suppressed, the noise is hardly applied, and the detection sensitivity of the electromagnetic wave is not greatly deteriorated.

Further, in a nondestructive inspection apparatus employing the electromagnetic wave detection module of the present invention configured as described above, it is possible to obtain superior effects in terms of cost and performance as compared with the case where the conventional module is employed.

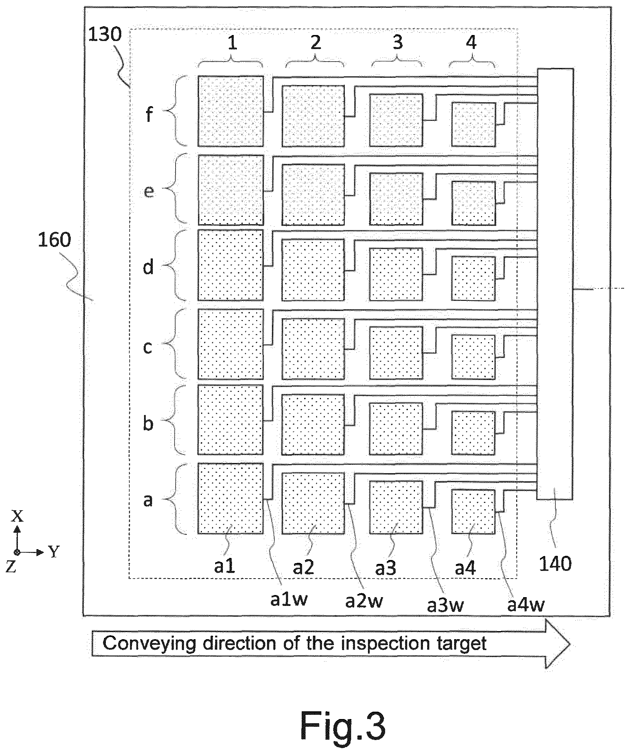

FIG. 3 is a diagram showing an example of the electromagnetic wave detection means 130 according to the first embodiment in which six detection element groups from row a to row f are arranged in the X-axis direction. Each detection element group includes four detection elements 1, 2, 3 and 4 arranged in Y-axis direction. In this example, the reading means 140 provided at outside one end on the surface of the substrate 160 in the Y-axis direction of the electromagnetic wave detection means 130 provided thereon, and the wirings connecting each detection element and the reading means 140 are formed on the substrate 160. In addition, for all the detection element groups, the wiring from each detection element belonging to the detection element group is routed through a gap between the detection element group and an adjacent detection element group on the same end side in the X-axis direction of the electromagnetic wave detection means 130. For example, the wirings alw to a4w respectively from the detection elements a1 to a4 belonging to the detection element group of the row a are routed through the gap between the detection element group of the row a and the detection element group of the row b adjacent thereto toward one end side direction in respect of the X-axis direction of the electromagnetic wave detection means 130. Similarly, the wirings respectively from the detection elements belonging to detection element group of the row b are also routed through the gap between the detection element group of the row b and the detection element group of the row c adjacent thereto toward one end side direction in respect of the X-axis direction of the electromagnetic wave detection means 130. The same applies to the respective wirings from the respective detection elements belonging to the respective detection element groups in the rows c to e. Note that although the detection element group does not exist on the same end side of each wiring from each detection element belonging to the detection element group of the row f, similarly, the wiring is routed to the same end side.

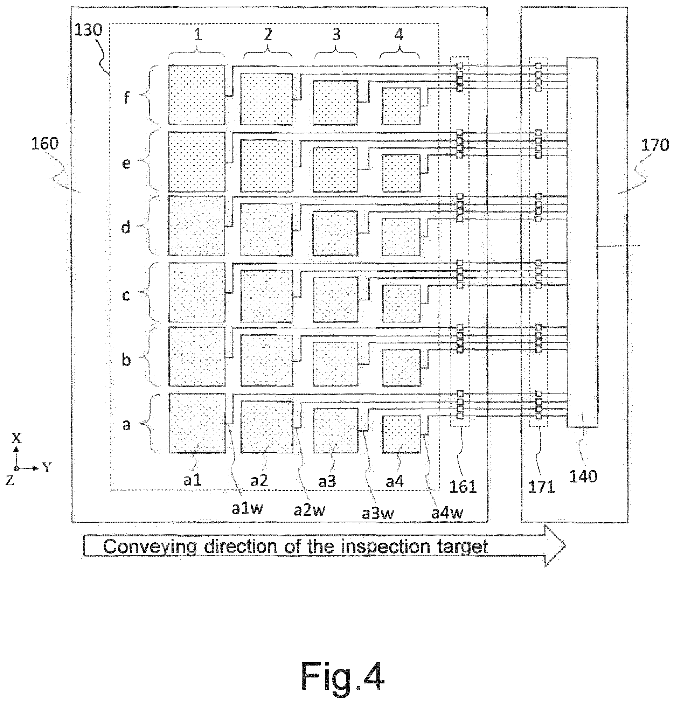

FIG. 4 is a diagram showing an example of the configuration in the case where the reading means 140 in the configuration of FIG. 3 is provided on another substrate 170. In this case, an array of terminals 161 for terminating respective wirings is provided on the substrate 160 instead of the reading means 140, and an array of terminals 171 connected to the reading means 140 via respective wirings is provided on the substrate 170 on which the reading means 140 is provided. Corresponding terminals in the array of terminals 161 and the array of terminals 171 are electrically connected by an arbitrary connection means.

### <Second Embodiment>

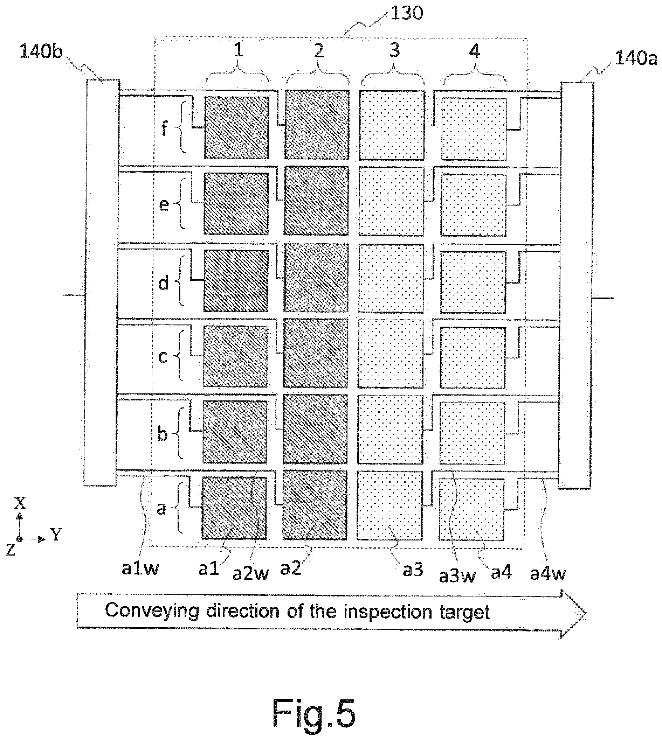

FIG. 5 is a diagram showing an example of the electromagnetic wave detection means 130 according to the second embodiment in which six detection element groups from row a to row f are arranged in the X-axis direction. Each detection element group is configured by arranging four detection elements 1, 2, 3 and 4 arranged in Y-axis direction.

In the electromagnetic wave detection means 130 of the first embodiment shown in FIG. 3, the reading means 140 which is a predetermined connection destination from each detection element is provided only outside one end in the Y-axis direction of the electromagnetic wave detection means 130, whereas in the electromagnetic wave detection means 130 of the present embodiment, the reading means 140a is provided outside one end in the Y-axis direction, and the reading means 140b is provided outside the other end in the Y-axis direction. However, the functions of the reading means 140 and the reading means 140a and 140b are the same, and only the number of connected wirings is different.

Then, for each detection element group, with respect to a space between a pair of adjacent elements as a reference, one side element(s) has/have electric wire connection(s) with a predetermined one side connection destination placed outside one end thereof, and the other side element(s) has/have electric wire connection(s) with the other side connection destination placed outside the other end thereof.

In the example of FIG. 5, for each detection element group, with the space between the detection element 2 and the detection element 3 among the detection elements 1, 2, 3, and 4 constituting the detection element group as a boundary, wirings from the detection elements 3 and 4 on one end side to the reading means 140a on the outside of the one end are formed, and wirings from the detection elements 1 and 2 on the other end side to the reading means 140b on the outside of the other end are formed, respectively. Thus, the number of wirings routed between the detection elements, which is four at most in the case of the first embodiment, can be reduced to two at most.

In this manner, by setting the reading means, which is a predetermined connection destination, to both ends in the Y-axis direction, the wiring paths are dispersed as compared with the case where the reading means is set at only one end or the other end, and it is possible to reduce the number of wirings passing between adjacent detection elements. Therefore, it is possible to further suppress the reduction of the exposed area of the detection element due to the presence of the wiring, and to further suppress the decrease of the detection sensitivity.

The boundary space determining which detection element is connected to a predetermined connection destination on one end side or to a predetermined connection destination on the other end side may be set so that the number of detection elements sandwiching the boundary becomes (M/2) when M is an even number, and ((M+1)/2) and ((M-1)/2) when M is an odd number.

For example, when the number of detection elements belonging to the detection element group is 4 (even number), if the boundary space is provided between the detection element 1 and the detection element 2 or between the detection element 3 and the detection element 4, the number of wirings passing between the detection elements is two at most, and the length of the longest portion of the wirings corresponds to length of two detection elements.

However, by setting the boundary space between the detection element 2 and the detection element 3, that is, as illustrated in FIG. 5 so that the number of detection elements sandwiching the boundary is (4/2), that is, two each, the number of wirings passing between the detection elements becomes one at most, and the length of the longest portion of the wirings corresponds to length of one detection element.

Further, for example, when the number of detection elements belonging to the detection element group is 5 (odd number), if a boundary space is provided between the detection element 1 and the detection element 2 or between the detection element 4 and the detection element 5, the number of wirings passing between the detection elements is three at most, and the length of the longest portion of the wirings corresponds to length of three detection elements.

However, by setting the number of detection elements sandwiching the boundary space to ((5+1)/2) and ((5-1)/2), i.e., 3 and 2, between the detection element 2 and the detection element 3 or between the detection element 3 and the detection element 4, the number of wirings passing between the detection elements becomes 2 at most, and the length of the longest portion of the wirings corresponds to length of two detection elements.

In this manner, by setting the boundary such that the number of detection elements sandwiching the boundary space is (M/2) when M is an even number and ((M+1)/2) and ((M-1)/2) when M is an odd number, the maximum value of the number of wirings routed between the detection elements can be made smaller, and the maximum length of the wirings can be made shorter. Therefore, it is possible to further suppress the decrease of the detection sensitivity and to further reduce the influence of noise on the wiring.

### <Third Embodiment>

With the configuration of the second embodiment, the effect of the TDI method can be further enhanced by appropriately changing the shape and position of each detection element belonging to the detection element group, which oppose the same detection target region, with respect to each detection element group.

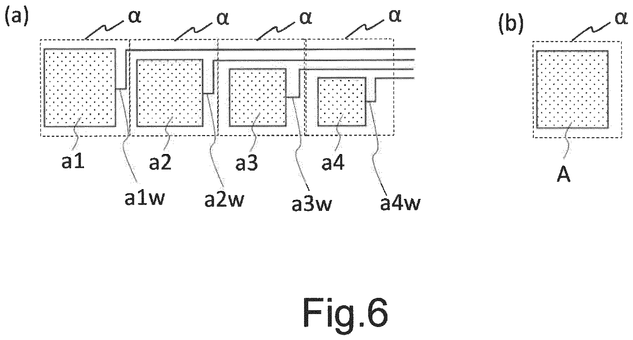

FIG. 6(a) shows a portion of the detection element group a partly copied from FIG. 3 showing the configuration of the electromagnetic wave detection means 130 of the first embodiment, and further shows a positional relationship between the detection target region α, indicated by dotted lines of the inspection target W as a detection target of the transmitted electromagnetic wave facing the detection elements a1 to a4 at the time of inspection. When the inspection target W moves from the left to the right in the drawing, the detection target region α moves in the order of the detection elements a1, a2, a3, and a4.

FIG. 6(b) shows a superimposed image in which each of the detection elements a1 to a4 capable of detecting a transmitted electromagnetic wave and the detection target region α are superimposed at a moment when the detection target region α is in a positional relationship facing each of the detection elements a1 to a4 at the time of inspection. In the region A obtained by superimposing, the detection range by the detection element a1 farthest from the reading means 40 is largest, and the other detection ranges of the detection elements get smaller as it approaches the reading means 40, and a smaller detection range is included in a larger detection range. That is, the region A is equivalent to the detection range of the detection element a1.

In order to increase the detection range of the plurality of stages of detection elements, a portion of the same detection target region in the inspection target W, in which each detection element detects the transmitted electromagnetic wave transmitted through the same detection target region, includes a part that does not overlap with a portion of the same detection target region in the inspection target W in which the detection element other than the detection element itself detects the transmitted electromagnetic wave. Specifically, for example, when each detection element belonging to the detection element group detects a transmitted electromagnetic wave, each detection element is provided so that the shape facing the same detection target region of the inspection target W and/or the positional relationship with the opposing same detection target region are different from each other.

However, although the shape and the positional relationship, in which the detection elements a1 to a4 are opposed to the same detection target region shown in FIG. 6(a), are examples, the degree of freedom of the shape and the degree of freedom of the position with respect to the predetermined region are small because it is necessary to arrange a shield between the detection elements in order to run wiring and to prevent the transmitted electromagnetic wave to be detected by the adjacent detection elements from being erroneously detected. These degrees of freedom become smaller as the number of detection elements belonging to the detection element group increases.

In contrast, as in the second embodiment, by dividing the reading means 140 into the reading means 140a and 140b, and arranging on both ends outside of the Y-axis direction of the electromagnetic wave detection means 130 as shown in FIG. 5, it is possible to increase the degree of freedom of the shape and the degree of freedom of the position with respect to a predetermined region as compared with when not dividing the reading means 140.

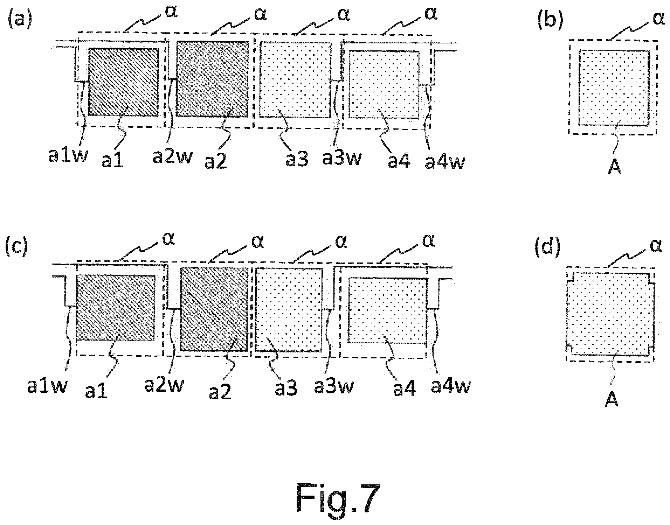

FIG. 7(a) shows a portion of the detection element group a partly copied from FIG. 5 showing the configuration of the electromagnetic wave detection means 130 of the second embodiment, and a positional relationship, in which the detection target region α of the inspection target W as a detection target of the transmitted electromagnetic wave faces the detection elements a1 to a4 at the time of inspection, is indicated by a dotted line. When the inspection target moves from the left to the right in the drawing, the detection target region α moves in the order of the detection elements a1, a2, a3, and a4.

FIG. 7(b) superimposes ranges respectively corresponding to the detection elements a1 to a4 in which each of the detection elements a1 to a4 can detect a transmitted electromagnetic wave in the detection target region α when the detection target region α is in a positional relationship facing each of the detection elements a1 to a4 at the time of inspection. In the region A obtained by superimposing, the detection ranges by the detection elements a2 and a3 far from the reading means 140b and 140a are large, while the detection ranges by the detection elements a1 and a4 close to the reading means 140b and 140a are small, and the latter detection ranges are included in the former detection ranges which are larger. That is, the region A is equal to the detection range of the detection elements a2 and a3.

However, in the configuration shown in FIG. 7(a), since there is a margin at both ends with respect to the detection elements a1 and a4 at both ends, and there is no wiring around the two detection elements a2 and a3 in the middle, for the each of four detection elements, a shape and a positional relationship facing the detection target region α at the time of inspection can be configured as shown in, for example, FIG. 7(c).

FIG. 7(d) superimposes ranges in which each of the detection elements a1 to a4 can detect a transmitted electromagnetic wave in the detection target region α when the detection target region α is in a positional relationship facing each of the detection elements a1 to a4 at the time of inspection in the case of the configuration shown in FIG. 7(c). As can be seen from a comparison of FIG. 7(d) with FIG. 7(d), the area A obtained by superimposing the four detection elements can be enlarged by mutually differing the shape and the positional relationship that oppose the area α to be detected at the time of inspection.

As a result, the transmitted electromagnetic wave from the detection target region of the inspection target W can be detected more widely while securing the wiring space, and the brightness of the pixel corresponding to the detection target region can be improved.

The present invention is not limited to the above embodiments. Each embodiment is exemplified, and any embodiment having substantially the same constitution as the technical idea described in the claims of the present invention and exhibiting the same operation and effect is included in the technical scope of the present invention. That is, the present invention can be suitably modified within the scope of the technical idea expressed in the present invention, and forms to which such modifications and improvements are added are also included in the technical scope of the present invention. For example, a plurality of electromagnetic wave detection modules of the present invention may be arranged in the X-axis direction to form an electromagnetic wave detection module array.

### Reference Signs List

- 30, 130: Electromagnetic wave detection means
- 40, 140, 140a, 140b: reading means
- 100: Nondestructive inspection apparatus
- 110: Electromagnetic wave irradiation means
- 120: Conveyance means
- 150: Adding means
- 151: Display means
- 160, 170: Substrate
- 161, 171: Array of Terminals
- W: Inspection target

## Claims

1. An electromagnetic wave detection module comprising on the same substrate surface:
an electromagnetic wave detection means in which detection element groups of M detection elements (M is an integer of 2 or more) arranged in the Y-axis direction are arranged in N rows (N is an integer of 2 or more) in the X-axis direction orthogonal to the Y-axis direction; and
M×N wirings electrically connecting each of the M×N detection elements and a predetermined connection destination outside one end of the electromagnetic wave detection means in the Y-axis direction.

2. The electromagnetic wave detection module according to claim 1, wherein, for all the detection element groups, the wiring from each detection element belonging to the detection element group is routed through a gap between the detection element group and an adjacent detection element group on the same end side in the X-axis direction of the electromagnetic wave detection means.

3. The electromagnetic wave detection module according to claim 1 or 2, wherein the predetermined connection destination is a connection destination set for each of the wirings and connected to each of the M×N detection elements in a one-to-one basis.

4. The electromagnetic wave detection module according to any one of claims 1 to 3, wherein the predetermined connection destination is also provided outside the other end of the electromagnetic wave detection means in the Y-axis direction, and
wherein, for each of the detection element group, the wiring from each detection element belonging to the detection element group is connected to a predetermined connection destination outside the one end from a detection element at one end with the middle of any adjacent detection element as a boundary, and the detection element at the other end is connected to a predetermined connection destination outside the other end.

5. The electromagnetic wave detection module according to claim 4, wherein the boundary is set such that the number of detection elements sandwiching the boundary is (M/2) when M is an even number and ((M+1)/2) and ((M-1)/2) when M is an odd number.

6. An electromagnetic wave detection module array configured by arranging a plurality of electromagnetic wave detection modules according to any one of claims 1 to 5 in the X-axis direction.

7. A nondestructive inspection apparatus comprising an electromagnetic wave detection module according to any one of claims 1 to 5 or an electromagnetic wave detection module array according to claim 6.

8. The nondestructive inspection apparatus according to claim 7 comprising:
an electromagnetic wave irradiation means for irradiating an inspection target with a predetermined electromagnetic wave; and
a conveyance means for conveying the inspection target placed on the conveyance plane in a predetermined direction,
wherein the electromagnetic wave detection module is arranged in a propagation path of the electromagnetic wave from the electromagnetic wave irradiation means to the electromagnetic wave detection module through the portion of the conveyance plane on which the inspection target is placed, such that the separation distance from the conveyance plane is shorter than the separation distance between the electromagnetic wave irradiation means and the conveyance plane, and the electromagnetic wave detection module is configured to detect the electromagnetic wave transmitted through the inspection target.

9. The nondestructive inspection apparatus according to claim 7 or 8 comprises a conveyance means for conveying an inspection target irradiated with an electromagnetic wave in a predetermined direction,
wherein the electromagnetic wave detection module is provided inside the conveyance means and detects the electromagnetic wave transmitted through the inspection target.
